# EUROPÄISCHE PATENTANMELDUNG

(11) **EP 1 130 406 A2**
(43) Veröffentlichungstag der Anmeldung: **05.09.2001**
(21) Anmeldenummer: 01103143.2
(22) Anmeldetag: 10.02.2001
(51) Int. Cl.: G01R 31/00

(54) **Verfahren und Anordnung zum Testen eines Prüflings**

(30) Priorität: 02.03.2000 AT 3392000
(71) Anmelder: Siemens AG Österreich, 1211 Wien (AT)
(72) Erfinder: Schinkowitsch, Bernhard, 2264 Jedenspeigen (AT)
(74) Vertreter: Peham, Alois, Dipl.-Ing.

(57) **Zusammenfassung**

Es wird ein Verfahren und eine Anordnung zum Testen eines Prüflings angegeben, bei dem die Durchführung des Tests mittels verschiedener Testmodule zumindest teilweise zeitlich parallel abläuft und die Kommunikation zwischen einem zentralen Steuerrechner und den einzelnen Testmodulen über ein Feldbussystem erfolgt. Aufgrund der Struktur des Feldbussystems ergeben sich geringer Verdrahtungsaufwand und einfache Lokalisierung und Behebung aufgetretener Störungen. Weiterhin wird der parallele Ablauf der Einzeltests unterstützt, woraus kurze Gesamtprüfungszeiten resultieren.

## Beschreibung

Die Erfindung betrifft ein Verfahren zum Testen eines Prüflings, insbesondere eines elektronisches Gerätes, bei dem die Ein- und Ausgabeeinheiten des Prüflings mit zumindest zwei verschiedenen Testmodulen hinsichtlich zumindest zwei verschiedener Funktionen getestet werden und der Ablauf des Tests durch ein in einem zentralen Steuerrechner laufendes Steuerprogramm gesteuert wird. Weiterhin betrifft die Erfindung eine Anordnung zur Durchführung des genannten Verfahrens.

Die zunehmenden Qualitätsansprüche an technische Geräte, beziehungsweise auch die weiterhin steigenden Stückzahlen der produzierten Apparate bedingen den Einsatz effizienter Testverfahren, um die Funktionstüchtigkeit der Prüflinge festzustellen.

Da die Fertigung heute weitgehend automatisch durchgeführt wird, ergibt sich auch die Forderung nach automatisch ablaufenden Prüfverfahren. Diese Verfahren sind beispielsweise Bestandteil des auf einer Fertigungsstrasse laufenden Produktionsprozesses, zumeist am Ende des Herstellungsprozesses, um die Qualität der Endprodukte festzustellen. Gegebenenfalls können aber auch Zwischenprodukte hinsichtlich ihrer Funktionstüchtigkeit überprüft werden, um Ausschussware vorzeitig aus dem Produktionsprozesses auszuscheiden.

Unabhängig davon können die erwähnten Prüfverfahren auch für einen Einzelprüfplatz eingesetzt werden, bei dem der Test an sich zwar vollautomatisch durchgeführt wird, das Zu- und Abführen von Prüflingen an die Testmodule jedoch vom zuständigen Qualitätssicherungspersonal besorgt werden muss. Diese Art der Prüfung wird vorwiegend bei Apparaten eingesetzt, die vom Anwender aufgrund eines während des Betriebs aufgetretenen Fehlers an den Hersteller zurückgesandt wurden.

Aufgrund der zunehmenden Komplexität der Prüflinge ist es oft nötig, die Prüfaufgabe auf zwei oder mehrere Testmodule aufzuteilen, die aufgrund ihrer Bauart jeweils für einen speziellen Teil des gesamten Tests optimal geeignet sind. Diese Aufteilung erfordert jedoch zusätzlich den Einsatz eines zentralen Steuerrechners, der die Zuteilung der Aufträge für die einzelnen Teile der Prüfung an die jeweiligen Testmodule übernimmt.

Die Testmodule selbst umfassen Schnittstellen zu den Ein- oder Ausgabeeinheiten der Prüflinge und sind aufgrund der großen Bandbreite von Funktionen technischer Geräte äußerst vielfältig. Im folgenden wird daher nur ein beispielhafter Auszug der vorkommenden Möglichkeiten für Eingabeeinheiten gegeben:
- mechanische Eingabeeinheiten wie Schalter, Tasten, Tastaturen, Touchscreens, Potentiometer oder dergleichen.
- Empfänger von Funkschnittstellen, beispielsweise nach dem GSM-Standard oder DECT-Standard arbeitend.
- optische Eingabeeinheiten wie zum Beispiel der Empfänger einer Infrarotschnittstelle.
- akustische Eingabeeinheiten, also vorwiegend Mikrofone.
- elektrische Eingabeeinheiten wie Empfänger von seriellen oder parallelen Schnittstellen.

Eingabeeinheiten sind jedoch nicht nur auf den Einsatz zur Weitergabe von Informationen beschränkt, sondern können beispielsweise auch der Energieversorgung technischer Geräte dienen:
- optische Eingabeeinheiten, beispielsweise also Solarzellen.
- elektrische Eingabeeinheiten wie die Ladebuchse eines mit Akkumulatoren betriebenen Gerätes.

Ebenso vielfältig wie die Eingabeeinheiten stellen sich auch die Ausgabeeinheiten dar, weswegen auch hier nur eine beispielhafte Auswahl der gegeben Möglichkeiten angeführt wird:
- mechanische Ausgabeeinheiten wie Druckerköpfe oder Geräte zur Darstellung der Brailleschrift.
- Sender von Funkschnittstellen, welche zum Beispiel nach dem GSM-Standard oder DECT-Standard arbeiten.
- Optische Ausgabeeinheiten, wie zum Beispiel der Sender einer Infrarotschnittstelle.
- Akustische Ausgabeeinheiten, also vorwiegend Lautsprecher.
- elektrische Ausgabeeinheiten, beispielsweise Sender von seriellen oder parallelen Schnittstellen.

Analog zu den Eingabeeinheiten sind unter Ausgabeeinheiten auch Vorrichtungen zu verstehen, die zum Beispiel zur Energieversorgung oder unter anderem auch zur Materialbearbeitung eingesetzt werden wie:
- mechanische Ausgabeeinheiten, wie der computergesteuerte Fräskopf einer Fräsmaschine zur Metallbearbeitung.
- elektrische Ausgabeeinheiten, beispielsweise der Ausgang eines Wechselrichters zur Umwandlung von Gleich- in Wechselstrom.

Es wird nochmals ausdrücklich darauf hingewiesen, dass aufgrund der Vielfalt der technischen Möglichkeiten hier nur ein Auszug von denkbaren Ein- und Ausgabeeinheiten angegeben werden kann.

Testmodule können gleichzeitig Ein- und Ausgabeeinheiten umfassen, also beispielsweise Sender und Empfänger einer bidirektionalen Infrarotübertragungsstrecke. Jedenfalls muss ein Testmodul immer das passende Gegenstück der auf dem Prüfling vorhandenen Ein- oder Ausgabeeinheit beinhalten. Ist auf dem Prüfling zum Beispiel für die Eingabeeinheit ein Mikrofon vorgesehen, so muss das Testmodul einen Lautsprecher zur Prüfung dieser Eingabeeinheit aufweisen. Sind beispielsweise auf dem Prüfling enthaltenen Tastaturen zu testen, bieten sich pneumatisch oder elektromagnetisch betätigte Stößel an, welche die entsprechenden Tasten mit einem definiertem Druck betätigen.

Aus der WO 98/45720, "Testsystem und Testverfahren" vom 15. Oktober 1998 ist es bekannt, dass elektrische Prüflinge hinsichtlich ihrer elektrischen Funktionen getestet werden können. Basierend auf einer vom Benutzer festzulegenden Testvorschrift wird der Testablauf von einem Steuermodul gesteuert, wobei die einzelnen, von den Testmodulen durchgeführten, Teilprüfungen sequentiell ablaufen. Die Gesamtdauer eines Testablaufs ergibt sich also als Summe der für die jeweiligen Teilprüfungen notwendigen Zeiten.

Ist die Gesamtdauer für die Funktionsprüfung eines technischen Gerätes größer als die Zeit, die zu dessen Herstellung nötig ist, müssen gegebenenfalls mehrere Prüfplätze für ein und das selbe Produkt vorgesehen werden. Um diese sehr aufwendige Methode zu umgehen, werden daher oft nur stichprobenartige Prüfungen durchgeführt, wodurch sich zwangsweise ein Qualitätsverlust der hergestellten Ware ergibt.

Es ist daher die Aufgabe der Erfindung, ein Verfahren anzugeben, welches das Testen von Prüflingen in besonders effizienter Weise ermöglicht.

Dies geschieht erfindungsgemäß mit einem Verfahren der eingangs genannten Art, bei dem die Durchführung des Tests mittels der zumindest zwei verschiedenen Testmodule zumindest teilweise zeitlich parallel abläuft und bei dem die Übermittlung der Testaufträge vom zentralen Steuerrechner zu einem Testmodul und Rückmeldungen vom Testmodul an den zentralen Steuerrechner über ein Feldbussystem erfolgt.

Wegen der parallel ablaufenden Einzeltests ist die Gesamtdauer für die Prüfung eines Prüflings gleich dem Zeitaufwand für den längsten Einzeltest. Können bestimmte Einzelprüfungen aufgrund ihrer Art und Weise nur sequentiell ablaufen, so ist die Zeitspanne für die am längsten dauernde Kombination heranzuziehen. In jedem Fall ergibt sich aber eine Zeitersparnis gegenüber rein sequentiell ablaufenden Einzeltests. Feldbussysteme eignen sich besonders gut zur Kommunikation zwischen Steuerrechner und den Testmodulen, beziehungsweise auch zur Kommunikation der Testmodule untereinander, beispielsweise zum Zweck der zeitlichen Synchronisation bestimmter Teilprüfungen. Ferner sind Feldbussysteme außerordentlich störungssicher und eventuell auftretende Fehler können wegen der Busstruktur leicht lokalisiert werden. Ausgestaltungen eines Feldbussystems sind beispielsweise der Profibus oder der CAN-Bus. Neben den bereits erwähnten Vorteilen spielt auch die einfach mögliche Änderung eines bereits bestehenden Testsystems, die in der Praxis häufig erforderlich ist, eine maßgebende Rolle. Durch die Busstruktur sind die Adressen der Testmodule nämlich im wesentlichen frei definierbar und in großer Zahl verfügbar. Feldbussysteme arbeiten vorwiegend mit elektrischen Signalen, denkbar ist jedoch auch der Einsatz von optischen Übertragungsmedien, beziehungsweise von Funkübertragungsstrecken. Darüber hinaus ist auch der gleichzeitige Einsatz von verschiedenen Ausgestaltungen eines Feldbussystems innerhalb eines Prüfsystems möglich.

Eine besonders vorteilhafte Variante der Erfindung sieht ein Verfahren vor, bei dem das im zentralen Steuerrechner laufende Steuerprogramm einen benutzerspezifischen Teil umfasst und dieser benutzerspezifische Teil des Steuerprogramms unabhängig von den an den zentralen Steuerrechner angeschlossenen Test- und Transportmodulen ist. Für den Verfasser einer den Testablauf steuernden Vorschrift ist detailliertes Wissen über die Struktur des Testsystems nicht erforderlich, da für diesen Teil des im Steuerrechner ablaufenden Programms nur globale Angaben über den Testablauf gemacht werden müssen. Die Anpassung an die tatsächlichen Gegebenheiten erfolgt getrennt von dieser unabhängigen Testvorschrift. So kann ein und das selbe Programm für einen Testablauf unverändert in einer Fertigungsstraße oder bei einem Einzelprüfplatz verwendet werden. Des weiteren ist auch eine Änderung des Testsystems, beispielsweise ein Austausch eines Testmoduls gegen ein moderneres, in dieser Hinsicht einfach durchzuführen, da lediglich der gerätespezifische Teil des im zentralen Steuerrechner laufenden Programms von dieser Änderung betroffen ist.

Vorteilhaft ist es auch, wenn mit Hilfe des im zentralen Steuerrechner laufenden Steuerprogramms die an den zentralen Steuerrechner angeschlossenen Testmodule und Transportmodule erkannt und diese entsprechend ihrer Art in den Testablauf eingebunden werden. Die notwendigen Anpassungen des benutzerspezifischen Teils des Steuerprogramms, der von den an den zentralen Steuerrechner angeschlossenen Test- und Transportmodulen unabhängig ist, an die tatsächlichen Gegebenheiten erfolgt in diesem Falle automatisch vom Steuerprogramm im Steuerrechner. Auf diese Weise wird ein Maximum an Benutzerfreundlichkeit erreicht. Verschiedene Konfigurationen von Testmodulen werden automatisch erkannt und können so durch ein und dieselbe Testvorschrift angesteuert werden. Ob das Testsystem Teil einer Fertigungsstraße ist, oder ob es sich um einen Einzelprüfplatz handelt, wird ebenfalls automatisch berücksichtigt. Auch der Ausfall eines Testmoduls führt nicht zum Ausfall des Testsystems, da die übrigen Einzeltests ohne Einschränkung durchgeführt werden können, sofern sie nicht vom funktionsuntüchtigen Testmodul abhängen. Die notwendigen Anpassungen können gegebenenfalls auch während der Laufzeit des Steuerprogramms erfolgen, sodass ein Neustart des Prüfsystems nicht erforderlich ist.

Eine günstige Ausgestaltung der Erfindung sieht ein Verfahren vor, bei dem mit Hilfe des im zentralen Steuerrechner laufenden Steuerprogramms die Bauart des Prüflings erkannt und der Testablauf entsprechend angepasst wird. Dieses Verfahren bringt Vorteile, wenn Geräte ungleicher Konstruktion geprüft werden sollen, die aber trotzdem gemeinsame Merkmale in sich vereinigen. Zum Beispiel können so mit ein und dem selben Steuerprogramm zwei an sich idente Mobiltelefone getestet werden, die sich lediglich durch den verwendeten Standard der Funkschnittstelle unterscheiden. Das Steuerprogramm erkennt den verwendeten Standard und passt den betreffenden Einzeltest entsprechend an. Der verbleibende Teil der Prüfung läuft dagegen unverändert ab.

Günstig ist es weiterhin, wenn mittels Steuerprogramm ein Bericht über das Ergebnis eines Tests erstellt und dieser Bericht in ein externes Datennetz weitergeleitet wird. Unter externen Datennetzen sind beispielsweise Local Area Networks, kurz LANs, oder aber auch das Internet zu verstehen. Denkbar ist auch das Übermitteln eines Testberichtes über drahtgebundene Telefonnetze, beziehungsweise über Mobilfunknetze. Die Weiterverarbeitung eines solchen Berichts kann also örtlich vollkommen unabhängig vom Testsystem erfolgen. Durch laufende Kontrolle der einzelnen Testberichte kann ein eventuell auftretender Qualitätsverlust der produzierten und überprüften Apparate frühzeitig erkannt werden und so der Fertigungsprozess rechtzeitig angehalten, beziehungsweise im Sinne einer Qualitätssteigerung der herzustellenden Geräte angepasst werden, um die Produktion von Ausschussware zu verhindern. Gegebenenfalls kann auch vereinbart werden, dass der Testbericht automatisch an den Abnehmer der produzierten und überprüften technischen Geräte übermittelt wird.

Vorteilhaft ist es ferner, wenn mittels zentralem Steuerrechner und den daran angeschlossenen Testmodulen auftretende Störungen im Testablauf erkannt werden, wenn entsprechend der aufgetretenen Störung ein Bericht erstellt wird und wenn dieser Bericht in ein externes Datennetz weitergeleitet wird. Dabei sind vor allem zwei Aspekte zu betrachten. Einerseits kann so der Benutzer des Testsystems über eventuell auftretende Störungen informiert werden, um so frühzeitig Gegenmaßnahmen ergreifen zu können, insbesondere wenn das Testsystem in eine Fertigungsstraße eingebunden ist. Die Anwesenheit des Benutzers direkt vor Ort ist hier jedoch nicht zwingend erforderlich, was ihm ermöglicht, sich neben der Überwachung des Testablaufes auch anderen Tätigkeiten zu widmen. Andererseits kann aber auch der Erzeuger des Testsystems über aufgetretene Fehler automatisch informiert werden, die das Testsystem an sich betreffen. So kann dieser seinerseits frühzeitig Fehler erkennen, gegebenenfalls beheben und so die Zufriedenheit seines Kunden auf besonders effiziente Weise erhöhen, beziehungsweise die Maßnahmen zur Fehlerbehebung auf ein Minimum reduzieren. Außerdem kann einem bestimmten Störfall auch ein bestimmter Empfänger oder eine Gruppe von Empfängern zugeordnet sein, um so die Benachrichtigung über eine aufgetretene Störung zum Beispiel direkt dem zuständigen Entwicklungsingenieur zuzustellen. Unter externen Datennetzen sind beispielsweise wiederum Local Area Networks, das Internet, drahtgebundene Telefonnetze oder Mobilfunknetze zu verstehen. Die Benachrichtigung erfolgt dabei unter Verwendung gängiger Datenformate, im Falle von klassischen Datennetzen beispielsweise per E-Mail, bei Mobilfunknetzen zum Beispiel mittels Short Message Service, kurz SMS, oder über das Wireless Application Protocol, kurz WAP.

Zur Durchführung des genannten Verfahrens wird eine Anordnung eingesetzt, bei der drei Testmodule über ein Feldbussystem an einen zentralen Steuerrechner angeschlossen sind und bei der diese Testmodule Schnittstellen zu den Ein- und Ausgabeeinheiten des Prüflings umfassen. Gegenüber der herkömmlichen Verdrahtung, wo für jedes Testmodul eine eigene Zweidrahtleitung zwischen Testmodul und zentralem Steuerrechner, beziehungsweise eine Eindrahtleitung bei gemeinsamer Masse, vorgesehen ist, ergibt sich wegen der Busstruktur eine wesentliche Vereinfachung beim Aufbau eines Testsystems. Ferner ist auch eine Änderung eines bestehenden Testsystems oder aber auch die Behebung einer aufgetretenen Störung sehr einfach durchzuführen.

Vorteilhaft ist es, wenn der zentrale Steuerrechner eine Schnittstelle zu weiteren Datennetzen umfasst. Unter externen Datennetzen sind beispielsweise Local Area Networks, das Internet, drahtgebundene Telefonnetze oder Mobilfunknetze zu verstehen. Diese Schnittstelle ermöglicht gegebenenfalls den Zugriff auf das Testsystem von jedem beliebigen Ort aus.

Günstig ist es weiterhin, wenn der zentrale Steuerrechner eine Schnittstelle zu einem Transportmodul umfasst, welches einen Prüfling zu den Testmodulen oder von diesen weg befördert. Auf diese Weise ist die Einbindung des Testsystems in eine Fertigungsstraße möglich. Aber auch bei Einzelprüfplätzen kann der Einsatz eines Transportmoduls sinnvoll sein, wenn das Zu- oder Abführen der Prüflinge zu den Testmodulen beispielsweise gefährlich ist, oder nur unter schwierigen Umständen bewerkstelligt werden kann.

Die Erfindung wird anhand einer Figur näher erläutert, die eine beispielhafte Anordnung für ein Testsystem zeigt, das für die Prüfung von Mobiltelefonen vorgesehen ist.

Die Hauptelemente der Anordnung sind ein Prüfling TEL, ein Transportmodul TRM, ein erstes bis fünftes Testmodul TM1..TM5 und der zentrale Steuerrechner STR.

Als Prüfling TEL ist ein Mobiltelefon vorgesehen, das eine Antenne ANT, eine Anzeigeeinheit DIS, eine erste bis vierte Eingabetaste T1..T4, eine externe Schnittstelle EXT und eine Ladebuchse LAD umfasst. Die externe Schnittstelle EXT und die Ladebuchse LAD befinden sich entgegen der üblichen Bauform an der Frontseite des Prüflings TEL um so zu einer übersichtlicheren Darstellung zu gelangen.

Das Transportmodul TRM umfasst in diesem Beispiel ein Förderband, welches den Prüfling TEL zum ersten bis fünften Testmodule TM1..TM5 und von diesen weg befördert, und eine Schnittstelle zum Anschluss an ein Feldbussystem, im gezeigten Beispiel an einen Profibus PB.

Das erste Testmodul TM1 besteht aus einem Mobilfunkprüfgerät GSM zum Testen der Funkschnittstelle des Prüflings TEL über die Antenne ANT. Dieses Prüfgerät umfasst eine Schnittstelle zu einem General Purpose Interface Bus GPIB, ein paralleles Bussystem, welches als Standard in der messtechnischen Datenübermittlung gilt. Das zweite Testmodul TM2 umfasst eine Videokamera CAM zur Beobachtung der Anzeigeeinheit DIS des Prüflings TEL und ein daran angeschlossenes Bildverarbeitungsmodul VID, welches eine Schnittstelle zu einem Profibus PB beinhaltet. Das dritte Testmodul TM3 besteht aus einer Pneumatikeinheit PNE und einer daran angeschlossenen Pneumatikanschlusseinheit PA, die den Anschluss an einen Profibus PB ermöglicht. Die Pneumatikeinheit PNE umfasst vier pneumatisch betätigte Stößel, die jeweils eine der ersten bis vierten Taste T1..T4 des Prüflings TEL betätigen können. Das vierte Testmodul umfasst eine Steckvorrichtung STV, die den Anschluss einer damit verbundenen Kommunikationseinheit COM an die externe Schnittstelle EXT des Prüflings TEL ermöglicht. Die Kommunikationseinheit COM verfügt über eine Schnittstelle zu einer seriellen Datenverbindung SER. Das fünfte Testmodul TM5 besteht aus einem Ladestecker LST und einem Energieversorgungsmodul ENV, welches mit dem Ladestecker LST verbunden ist, und eine Schnittstelle zum Profibus PB umfasst. Der Ladestecker LST ermöglicht die Verbindung zwischen der Ladebuchse LAD des Prüflings TEL und dem Energieversorgungsmodul ENV.

Der zentrale Steuerrechner STR umfasst Schnittstellen zu zwei verschiedenen Feldbussystemen, dem Profibus PB und dem General Purpose Inferface Bus GPIB. Weiterhin beinhaltet der zentrale Steuerrechner eine Verbindung zu einem externen Datennetz NET, eine Verbindung zu einem Drucker DRU und eine Schnittstelle zu einer seriellen Datenverbindung SER.

Das erste Testmodul TM1 ist über einen General Purpose Interface Bus GPIB mit dem zentralen Steuerrechner STR verbunden. Der Anschluss des Transportmoduls TRM, des zweiten Testmoduls TM2, des dritten Testmoduls TM3 und des fünften Testmoduls TM5 an den zentralen Steuerrechner STR erfolgt über einen Profibus PB, der die einzelnen Module kettenartig miteinander verbindet. Das vierte Testmodul TM4 ist über eine serielle Datenverbindung SER an den zentralen Steuerrechner STR angeschlossen.

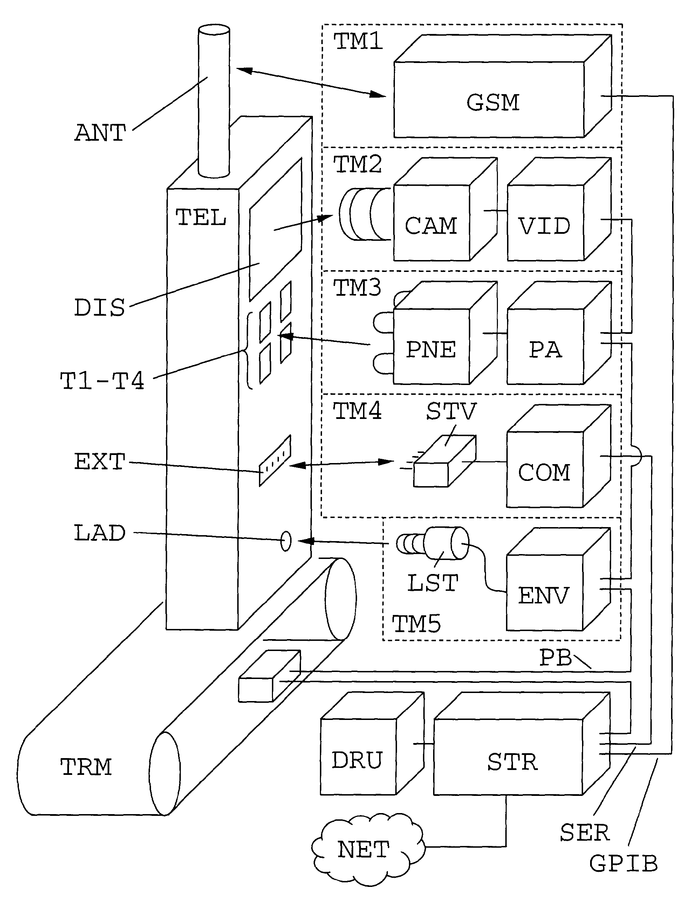

In der Figur werden die Informations- beziehungsweise Energieflüsse durch Pfeile symbolisiert. Eine bidirektionale Verbindung besteht einerseits zwischen dem ersten Testmodul TM1 und der Antenne ANT, andererseits auch zwischen dem vierten Testmodul TM4 und der externen Schnittstelle EXT des Prüflings TEL. Von der Anzeigeeinheit DIS kann Information nur an das zweite Testmodul TM2 übertragen werden und nicht umgekehrt. Desgleichen kann die erste bis vierte Taste T1..T4 des Prüflings TEL nur vom jeweiligen Stößel der Pneumatikeinheit PNE des dritten Testmoduls TM3 betätigt werden. Vom fünften Testmodul TM5 wird lediglich der in die Ladebuchse LAD fließenden Ladestrom erfasst, weswegen hier der Pfeil vom fünften Testmodul TM5 zur Ladebuchse LAD des Prüflings TEL weist.

Die Funktion der in der Figur dargestellten Anordnung ist wie folgt:

Mittels eines im zentralen Steuerrechner STR laufenden Steuerprogramms wird die vorliegende Anordnung analysiert und der Testablauf den angeschlossenen Module angepasst. Da es sich bei der gezeigten Anordnung um ein in eine Fertigungsstraße eingebundenes Testsystem handelt, wird ein Befehl vom Steuerprogramm an das Transportmodul TRM übermittelt, einen Prüfling TEL so an das erste bis fünfte Testmodul TM1..TM5 zu befördern, dass die darauf folgende Prüfung durchgeführt werden kann. Das Transportmodul TRM führt diesen Befehl aus und sendet eine Bestätigung dafür an den zentralen Steuerrechner STR. Die Kommunikation zwischen Transportmodul TRM und zentralem Steuerrechner STR erfolgt dabei unter Verwendung des Profibus PB.

Da mit der gezeigten Anordnung verschiedene Typen von Prüflingen TEL getestet werden können, wird ein Befehl vom zentralen Steuerrechner STR an das zweite Testmodul TM2 gesendet, die Produktbezeichnung des Prüflings TEL zu analysieren. Das Ergebnis wird nach erfolgter Ermittlung des Produkttyps vom zweiten Testmodul TM2 an den zentralen Steuerrechner STR übermittelt. Denkbar ist es aber auch, dass Informationen über die Bauart des vorliegenden Produkttyps über das externe Datennetz NET erhalten werden. Mit Hilfe des im zentralen Steuerrechner STR ablaufenden Steuerprogramms wird der Testablauf nun entsprechend des zu testenden Produkttyps angepasst. Die vom Qualitätssicherungspersonal verfasste Testvorschrift ist von den tatsächlichen Gegebenheiten so weit entkoppelt, dass diese von den erfolgten Anpassungen unberührt bleibt.

Nachdem nun die Bauart aller angeschlossenen Module und der Typ des Prüflings TEL ermittelt wurden, wird mit Hilfe des Steuerprogramms die eigentliche Prüfung gestartet. Durch das Steuerprogramm wird zuallererst das vierte Testmodul TM4 veranlasst, die Verbindung zwischen der externen Schnittstelle EXT des Prüflings TEL und der Steckvorrichtung STV herzustellen. Analog dazu wird ein entsprechender Befehl vom zentralen Steuerrechner an das fünfte Testmodul TM5 gesandt, den Ladestecker LST mit der Ladebuchse LAD des Prüflings TEL zu verbinden.

Darauf hin werden Befehle vom zentralen Steuerrechner STR an das erste bis fünfte Testmodul TM1..TM5 geschickt, nun mit den Einzeltests zu beginnen. Im gezeigten Beispiel werden zwei Prüfschleifen gebildet. Bei der ersten Prüfschleife betätigt das dritte Testmodul TM3 mit Hilfe der Stößel der Pneumatikeinheit PNEU die erste bis vierte Taste T1..T4 des Prüflings TEL. Die jeweils gedrückte Taste wird auf der Anzeigeeinheit DIS dargestellt und durch das zweite Testmodul TM2 ausgewertet. Die zweite Prüfschleife beginnt beim vierten Testmodul TM4, über welches ein Datenmuster an die externe Schnittstelle EXT des Prüflings TEL übermittelt wird. Dieses Datenmuster wird mit Hilfe des im Prüfling TEL ablaufenden Betriebssystems über die Antenne ANT ausgestrahlt und vom ersten Testmodul TM1 empfangen. Die zweite Prüfschleife kann grundsätzlich aber auch in umgekehrter Reihenfolge durchlaufen werden, wobei das erste Testmodul TM1 ein Datenmuster über die Antenne ANT an die Funkschnittstelle des Prüflings TEL sendet und dieses über die externe Schnittstelle EXT an das vierte Testmodul TM4 übermittelt wird. Durch das fünfte Testmodul TM5 wird im gezeigten Beispiel lediglich der Ladestrom des Energieversorgungsmoduls ENV überwacht. Die beiden Prüfschleifen, sowie die Überwachung des Ladestroms laufen unabhängig voneinander und damit zeitlich parallel ab.

Um den parallelen Ablauf der Einzeltests noch besser zu unterstützen, kann auch ein für diesen Zweck ausgerichteter Testmodus im Betriebssystem des Prüflings TEL vorgesehen sein.

Zur zeitlichen Synchronisation können das zweite Testmodul TM2 und das dritte Testmodul TM3 gegebenenfalls auch ohne Einbeziehung des zentralen Steuerrechners STR über den Profibus PB miteinander kommunizieren.

Um den Test der Anzeigeeinheit DIS zu komplettieren, wird abschließend eine Prüfschleife zwischen dem vierten Testmodul TM4, dem Prüfling TEL und dem zweiten Testmodul TM2 gebildet. Dabei wird ein vom vierten Testmodul TM4 an die externe Schnittstelle EXT gesendetes Datenmuster vom Betriebssystem des Prüflings TEL an die Anzeigeeinheit DIS übermittelt. Die angezeigten Muster, welche speziell auf den Test der Anzeigeeinheit DIS ausgerichtet sind, werden schließlich durch das zweite Testmodul TM2 ausgewertet.

Die Bestätigung über den ausgeführten Befehl und die Ergebnisse der Einzeltests, werden von den jeweiligen Testmodulen zeitlich asynchron an den zentralen Steuerrechner STR übermittelt. Diese Informationen werden mit Hilfe des Steuerprogramms, welches im zentralen Steuerrechner STR abläuft, gesammelt und zu einem Gesamtbericht zusammengestellt. Dieser Bericht wird über das externe Datennetz NET an einen im Steuerprogramm definierten Empfänger zugestellt, beispielsweise an eine zentral geführte Datenbank zur Speicherung von Daten, die für die Qualitätssicherung bedeutsam sind.

Tritt eine Störung des Testablaufes auf, so wird dies vom betreffenden Modul an den zentralen Steuerrechner STR gemeldet, insbesondere dann, wenn die Störung nicht durch das Modul selbst behoben werden kann. Mit Hilfe des im zentralen Steuerrechner STR ablaufenden Steuerprogramms werden daraufhin weitere Maßnahmen eingeleitet, gegebenenfalls die Übermittlung einer entsprechenden Störungsmeldung an einen im Steuerprogramm definierten Empfänger über das externe Datennetz NET.

Nach dem Abschluss der Prüfung wird ein Befehl vom zentralen Steuerrechner STR an das Transportmodul TRM übermittelt, den getesteten Prüfling TEL vom ersten bis fünften Testmodul TM1..TM5 wegzubefördern und einen neuen Prüfling TEL zuzustellen. Der Zyklus beginnt an dieser Stelle von neuem und läuft in der beschriebenen Weise weiter ab.

Die Aufteilung der Aufgaben entsprechend des gezeigten Beispiels ist nicht zwingend. Vielmehr können die Einzelaufgaben dem zentralen Steuerrechner STR und den daran angeschlossenen Modulen in der Weise zugeteilt werden, dass eine optimale Gesamtwirkung erzielt wird. Diese Optimierung kann beispielsweise hinsichtlich einer möglichst kurzen Gesamtprüfzeit oder aber auch einer hinsichtlich der Funktion des Prüflings TEL weitgehend vollständigen Prüfung erfolgen.

## Patentansprüche

1. Verfahren zum Testen eines Prüflings, insbesondere eines elektronisches Gerätes, bei dem die Ein- und Ausgabeeinheiten des Prüflings mit zumindest zwei verschiedenen Testmodulen hinsichtlich zumindest zwei verschiedener Funktionen getestet werden und der Ablauf des Tests durch ein in einem zentralen Steuerrechner laufendes Steuerprogramm gesteuert wird,
**dadurch gekennzeichnet,**
dass die Durchführung des Tests mittels der zumindest zwei verschiedenen Testmodule (TM) zumindest teilweise zeitlich parallel abläuft und dass die Übermittlung der Testaufträge vom zentralen Steuerrechner (STR) zu einem Testmodul (TM) und Rückmeldungen vom Testmodul (TM) an den zentralen Steuerrechner (STR) über ein Feldbussystem erfolgt.

2. Verfahren nach Anspruch 1, **dadurch gekennzeichnet**, dass das im zentralen Steuerrechner (STR) laufende Steuerprogramm einen benutzerspezifischen Teil umfasst und dieser benutzerspezifische Teil des Steuerprogramms unabhängig von den an den zentralen Steuerrechner (STR) angeschlossenen Testmodulen (TM) und Transportmodulen (TRM) ist.

3. Verfahren nach einem der Ansprüche 1 bis 2, **dadurch gekennzeichnet,** dass mit Hilfe des im zentralen Steuerrechner (STR) laufenden Steuerprogramms die an den zentralen Steuerrechner (STR) angeschlossenen Testmodule (TM) und Transportmodule (TRM) erkannt und diese entsprechend ihrer Art in den Testablauf eingebunden werden.

4. Verfahren nach einem der Ansprüche 1 bis 3, **dadurch gekennzeichnet**, dass mit Hilfe des im zentralen Steuerrechner (STR) laufenden Steuerprogramms die Bauart des Prüflings (TEL) erkannt und der Testablauf entsprechend angepasst wird.

5. Verfahren nach einem der Ansprüche 1 bis 4, **dadurch gekennzeichnet,** dass mittels Steuerprogramm ein Bericht über das Ergebnis eines Tests erstellt und dieser Bericht in ein externes Datennetz (NET) weitergeleitet wird.

6. Verfahren nach einem der Ansprüche 1 bis 5, **dadurch gekennzeichnet,** dass mittels zentralem Steuerrechner (STR) und der daran angeschlossenen Testmodule (TM) auftretende Störungen im Testablauf erkannt werden, dass entsprechend der aufgetretenen Störung ein Bericht erstellt wird und dass dieser Bericht in ein externes Datennetz (NET) weitergeleitet wird.

7. Anordnung zur Durchführung des Verfahrens nach einem der Ansprüche 1 bis 6,
**dadurch gekennzeichnet,**
dass zumindest zwei Testmodule (TM) über ein Feldbussystem an einen zentralen Steuerrechner (STR) angeschlossen sind und dass diese Testmodule (TM) Schnittstellen zu den Ein- und Ausgabeeinheiten des Prüflings (TEL) umfassen.

8. Anordnung nach Anspruch 7, **dadurch gekennzeichnet,** dass der zentrale Steuerrechner (STR) eine Schnittstelle zu weiteren Datennetzen (NET) umfasst.

9. Anordnung nach einem der Ansprüche 7 bis 8, **dadurch gekennzeichnet,** dass der zentrale Steuerrechner (STR) eine Schnittstelle zu einem Transportmodul (TRM) umfasst, welches einen Prüfling (TEL) zu den Testmodulen (TM) oder von diesen weg befördert.
